# EUROPEAN PATENT APPLICATION

(11) **EP 2 216 831 A1**
(43) Date of publication of application: **11.08.2010**
(21) Application number: 09152213.6
(22) Date of filing: 05.02.2009
(51) Int. Cl.: H01L 31/18, C23C 16/458, C23C 14/56

(54) **Modular PVD system for flex PV**

(71) Applicant: Applied Materials, Inc., Santa Clara, CA 95054 (US)
(72) Inventor: Hein, Stefan, 63825 Blankenbach (DE); Herzog, Andre, 63755 Alzenau (DE); Sauer, Peter, 36381 Schluechtern (DE); Morrison, Neil, 63654 Buedingen (DE)
(74) Representative: Zimmermann & Partner

(57) **Abstract**

A system for thin film deposition on a flexible substrate having at least a first deposition region is described. The system includes a first chamber being based on a platform, wherein the first deposition region is within the first chamber, wherein the first chamber has a first support member configuration configured for supporting at least two different substrate guiding systems and wherein one substrate guiding system is supported by the first support member configuration, and wherein the platform is configured for at least two different deposition units and wherein one deposition unit of the at least two different deposition units is enclosed by the first chamber.

## Description

### TECHNICAL FIELD OF THE INVENTION

Embodiments of the present invention relate to a modular PVD system for depositing thin layers on flexible substrates, and which can be used for manufacturing layer stacks of flex PV modules. In particular, embodiments relate to a thin-film deposition system having one or more chambers, which are based on a common platform. Specifically, they relate to a system for thin film deposition on a flexible substrate; and to a method of manufacturing a layer stack of a flexible photo voltaic cell with such a system.

### BACKGROUND OF THE INVENTION

The current trend of an increasing number of electronic and optoelectronic devices such as printed circuit boards, displays and solar cells on flexible substrates has the desire to use cheap substrates to make the devices cheaper. Accordingly, there is an increasing need for and an increasing development of roll-to-roll thin film deposition apparatuses. Thus, there is a desire for deposition platform concepts that permit low cost deposition for different substrate materials and different stacks of thin film layers.

For thin film deposition systems in the field of manufacturing consumer electronic devices, downtimes of systems is a serious and challenging factor. Thereby, stock holding of spare parts or deposition components of e.g. an inline processing line in a factory and maintenance are only a few of the aspects that need to be considered. Additionally, manufacturing costs for manufacturing the deposition equipment needs to be decreased for low cost production of the consumer electronic and optoelectronic devices. Of course, these considerations have to be taken into account on top of optimized deposition characteristics for each of the layers deposited in a layer stack.

### SUMMARY OF THE INVENTION

In light of the above, a system for thin film deposition on a flexible substrate according to independent claim 1 and a method of manufacturing a layer stack of a flexible photo voltaic cell according to independent claim 11 are provided.

According to one embodiment, a system for thin film deposition on a flexible substrate having at least a first deposition region is provided. The system includesa first chamber being based on a platform, wherein the first deposition region is within the first chamber, wherein the first chamber has a first support member configuration configured for supporting at least two different substrate guiding systems and wherein one substrate guiding system is supported by the first support member configuration, and wherein the platform is configured for at least two different deposition units and wherein one deposition unit of the at least two different deposition units is enclosed by the first chamber.

According to a further embodiment, a method of manufacturing a layer stack of a flexible photo voltaic cell is provided. The method includes unwinding a flexible substrate from a roll; guiding the flexible substrate in a first chamber being based on a common platform; depositing a first layer on the flexible substrate; guiding the flexible substrate from the first chamber to a second chamber, wherein the second chamber is based on the second platform; depositing a second layer above the first layer; guiding the flexible substrate from the second chamber; and winding the flexible substrate on a roll.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
Figure 1 shows a schematic view of a first deposition system according to embodiments described herein;
Figures 2A and 2B show a chamber providing a platform for chambers of deposition systems according to embodiments described herein;
Figure 3 shows a guiding system for a flexible substrate according to embodiments described herein and which can be used with the platform of deposition systems;
Figure 4 shows a schematic view of another guiding system for a flexible substrate according to embodiments described herein;
Figure 5 shows a deposition unit according to embodiments described herein which can be used with the platform for deposition systems;
Figure 6 shows a yet further deposition unit according to embodiments described herein, which can be used with the platform for providing a system for thin film deposition;
Figure 7 shows a schematic view of a modification of a deposition system according to embodiments described herein;
Figure 8 shows a schematic view of a yet further modification of deposition systems according to embodiments described herein;
Figure 9 shows a schematic view of a yet further system for thin film deposition on a flexible substrate according to embodiments described herein; and
Figure 10 shows a schematic view of a yet further system for thin film deposition on a flexible substrate according to embodiments described herein

### DETAILED DESCRIPTION OF THE EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a deposition platform concept that permits low cost deposition irrespective of the substrate material and thickness used. Currently, the majority of flexible photovoltaic devices is manufactured on stainless steel, aluminum, PET or PEN substrates, whereas polyimide is used almost exclusively for flexible printed circuit boards and both PET and PEN are used for flexible displays. For example, typically the substrate thickness can be 25 µm to 150 µm and used dependent upon both the heat load delivered to the substrate and the desired final product's mechanical properties.

A flexible substrate or web as used within the embodiments described herein can typically be **characterized in that** it is bendable. The term "web" may be synonymously used to the term "strip" or the term "flexible substrate". For instance, the web as described in embodiments herein may be a foil as described above.

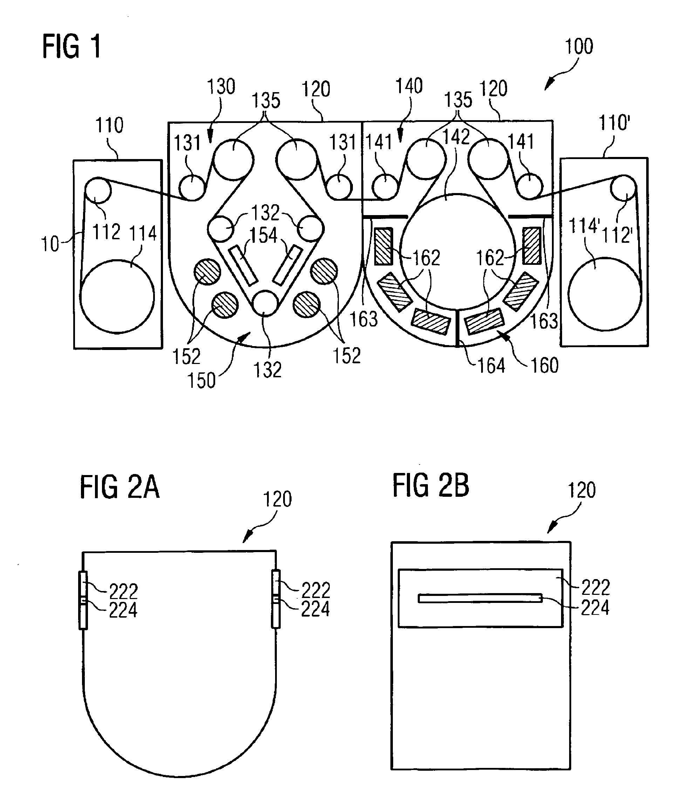

According to embodiments described herein, a thin film deposition system 100, as shown in FIG. 1 can be provided. Therein, an unwinding station 110 is provided with a roll 114 providing a flexible substrate 10. Further, the unwinding station 110 includes a guiding roller 112. Generally, one or more guiding rollers can be provided in order to guide the substrate to the subsequent chamber, to tension the web to the desired tension, to control the speed of the web, or the like.

From the unwinding station 110, the flexible substrate is guided to the first deposition chamber 120 and to a second deposition chamber 120 and further to a winding station where the flexible substrate is wound on a roll 114' in the winding station 110'. Again, the winding station 110' can include one or more rollers 112' in order to guide the flexible substrate and to control tension, winding characteristics, or the like.

Each of the chambers used in the thin film deposition system, i.e. in FIG. 1 the first (left) chamber 120 and a second (right) chamber 120 can include a plurality of guiding rollers 131, 141 to guide the flexible substrate to the desired deposition areas and to control the transport of the web.

As shown in FIG. 1, the first chamber 120 may include a free span substrate guiding system having rollers 132 such that the web is not in contact with a roller between the rollers 132, i.e. in the zones at which deposition takes place. According to some embodiments, which can be combined with other embodiments described herein, the free span substrate guiding system can be combined with a plurality of rotatable cathodes, for example magnetron sputtering cathodes, which are used to deposit the desired material onto the substrate 10. Typically, according to yet further embodiments, heating elements 154 are provided on the opposing side of the substrate 10 to heat the substrate to the desired temperature.

According to yet further embodiments, which can be combined with other embodiments described herein, the substrate guiding system used in the first (left) chamber in FIG. 1 further includes two gas cushion rollers 135. Thereby, the substrate 10, which is guided through the deposition system 100, faces the gas cushion roller surface with the front face of the substrate. Thereby, the front face or front surface of the substrate is to be understood as the surface on which the layers are deposited. However, based on the fact that rollers 135 are gas cushion rollers, there is no harmful mechanical contact of the substrate 10 with respect to the gas cushion rollers 135.

Examples of a gas cushions, which can be used with embodiments described herein, are described in U.S. patent application Ser. No. 12/255,389 , entitled " Hover cushion transport for webs in a web coating process" filed October 21, 2008, which is incorporated herein by reference to the extent the applications are not inconsistent with this disclosure. Therein, for example, a guiding device for contact-free guiding a web is provided with the device having a surface for facing the web and a multitude of gas outlets disposed in the surface and adapted for providing a hover cushion for the web; or a guiding device for contact-free guiding a web is provided with the device having a surface for facing the web and a multitude of gas outlets disposed in the surface wherein the surface is non-rotatable.

According to yet further embodiments, which can be combined with other embodiments described herein, the gas passing through the gas outlets can be used to control the temperature of the web. Thus, means for cooling or heating the gas passing through the gas outlets can be provided such that the temperature of the web being guided by the gas cushion roller can be increased or decreased depending on the desired temperature for the subsequent deposition process.

After deposition in the first chamber 120, the substrate 10 is guided to the second (right) chamber 120. Therein, guiding rollers 141 can be provided similarly as the guiding rollers 131 in the last chamber. The substrate guiding system 140 in the right chamber 120 includes, in the example shown in FIG. 1, two gas cushion rollers 135 and a drum 142. Typically, the drum 142 is a cooling drum such that the substrate 10 can be cooled while guided over the drum 142 and while deposited in the chamber.

As shown in FIG. 1, gas separation members 163 can be provided such that the deposition region and the region in which the gas cushion rollers 135 are provided are separated. Accordingly, a sufficiently high gas pressure, i.e. a sufficient amount of gas, can be provided for contact-less floating of the flexible substrate on the gas cushion rollers. According to these embodiments, a gas separation unit, can be provided for any of the chambers inclosing one or more gas cushion rollers, which are described herein. Thereby, the gas inserted by the gas cushion roller can be prevented from deteriorating the vacuum condition in the deposition areas of the chambers.

According to embodiments described herein, the substrate guiding system 140 in the right chamber and the substrate guiding system 130 in the left chamber can both be provided in the same chamber housing. In light of the above, according to different embodiments described herein, which can be combined with other embodiments described herein, the chamber 120 provides a common or uniform platform for different substrate guiding systems 130, 140 and different deposition units 150 and 160. Thus, the modularity of the deposition system can be provided. This improves the flexibility of a factory for manufacturing consumer electronic devices, it reduces the number of spare parts that need to be provided for avoiding significant downtimes of the deposition system, it increases the flexibility for combining different deposition processes, or reduces the costs for manufacturing deposition chambers and, thus, deposition systems.

Thereby, a "universal" roll-to-roll platform designed for example for the type of PVD processes found particularly in "Flex PV" includes the high temperature deposition of the aluminum back contact. In order to achieve the desired aluminum back contact properties (e.g. surface roughness) free span deposition can be provided and a cooling roller or cooling drum can be used to reduce the substrate temperature thereafter prior to the next PVD back contact process step (e.g. TCO deposition). As the TCO deposition typically uses a coating drum system, modularity is therefore beneficial for embodiments described herein.

According to yet further embodiments, which can be combined with other embodiments described herein, the modularity for providing different substrate guiding units allows a cooling or heating of the web between different processes. Thereby, the system can be adapted for a transport speed of the flexible substrate is from 0.1 m/min to 10 m/min, typically the processes are conducted at a substrate speed of about 1 m/min to 5 m/min. Accordingly, typical implementations can have a time between the depositing of the first layer and the time between depositing a second layer of about 10 min or less, typically 5 min or less, or even 1 min/less.

According to embodiments describe herein, a high temperature of about 400 °C and above, e.g. about 500 °C can be provided in the first (left) chamber 120 of Fig. 1. The high temperature can be used for the deposition of an aluminum back contact layer of a flexible solar cell with the desired optical and electrical characteristics. According to some embodiments, these characteristics can be a diffuse light scattering and/or low electrical resistance.

Immediately thereafter, a second PVD process is used for the deposition of the ZnO back contact capping/scattering layer within the same PVD system. The second deposition process can thereby typically be a process carried out at a substrate temperature of 100°C or below. For example, the second process can be a room temperature process wherein the substrate temperature might however be slightly elevated above room temperature due to the energy provided to the substrate during the deposition process. Due to the large difference in substrate temperature between these two processes inline, roll-to-roll processing according to embodiments described herein provide a method of accurately and controllably cooling the flexible substrate.

The modular design described within with respect to embodiments described herein, permits the combination of a processing system with a free-span substrate transport and processing system with a cooling drum/roller transport between a single set of unwinding and winding rollers. Furthermore, this modularity can be provided by similar vacuum chambers forming a common platform for containing different internal substrate transport and processing systems.

As described with respect to Fig. 1, according to some embodiments, a gas cushion substrate transport system can be further provided in order to minimize coated surface (front) contact and potential damage that might occur when the front surface of the web is in mechanical contact with a drum or a roller. This gas cushion may also be used to control heat transfer to/from the substrate during transport.

FIGS. 2A and 2B show different schematic side views of a chamber 120 which is used as a common platform for an in-line thin film deposition system and which can enclose different substrate guiding systems and different deposition units or deposition unit assemblies. The chamber 120 has flanges 222 with openings 224 on opposing sides thereof. During operation, a flexible substrate can enter and exit the chamber 120 from a neighboring chamber through the openings 224. The flanges 222 can be used to seal the chamber 120 with respect to an outer atmosphere and connect one chamber 120 to a neighboring chamber such that the thin film deposition systems can be evacuated. According to yet further embodiments, which can be combined with other embodiments described herein, a flange for connecting a vacuum system, such as a vacuum pump, a flange or flanges for providing processing gases or a plurality of processing gases, and/or flanges for electrically connecting the substrate guiding system and the deposition units with respective controllers can be provided for the chamber. Typically, these flanges are provided in the form of a common platform concept such that the different assemblies, which can be enclosed in the chamber 120, are each connected to the same flange configuration.

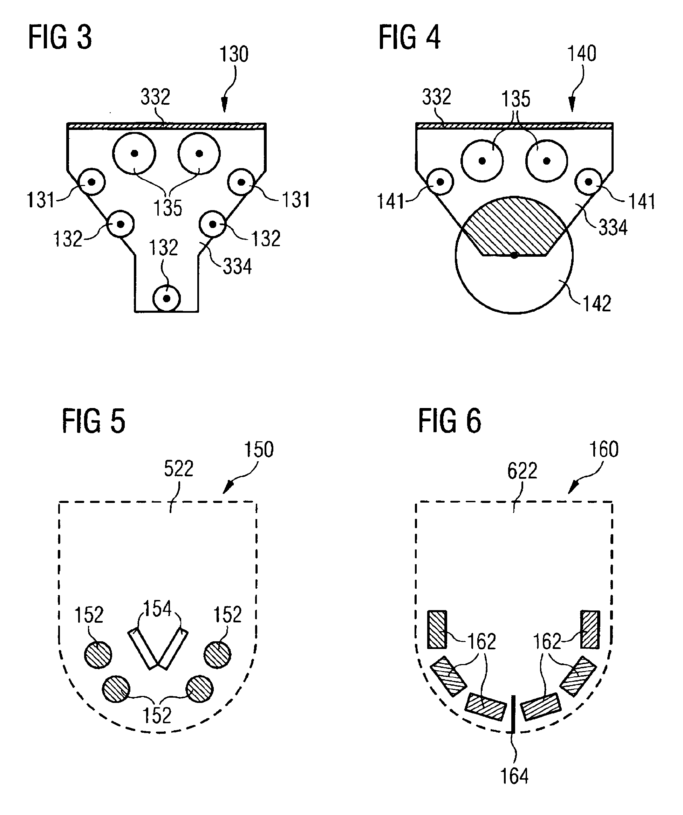

As shown in FIGS. 3 and 4, substrate guiding systems 130 and 140 can be provided. Each of the substrate guiding systems have a support structure, for example with a first plate 332 and a second plate 334. According to some embodiments, which can be combined with other embodiments described herein, the first plate 332 can be fixed to the roof of the chamber 120 shown in FIG. 2A. Thereby, different substrate guiding systems can be provided in and connected to the same chamber platform.

FIG. 3 shows a free span substrate guiding system 130. The substrate guiding system shown in FIG. 3 includes two gas cushion rollers 135 and two substrate guiding rollers 131. Further, two or more, for example three rollers 132 are provided, which form a free span substrate guiding system such that deposition areas or deposition zones are provided between the rollers 132.

FIG. 4 shows a substrate guiding system 140 having a drum 142. Therein, the substrate is processed while the web is guided over the drum 142. Further, web guiding rollers 141 and gas cushion rollers 135 can be provided according to some embodiments described herein. According to yet further embodiments, typically the drum 142 can be cooled with a cooling fluid provided in cooling channels in the drum 142. Accordingly, the substrate temperature can be controlled during a deposition process and can be adapted to be for example 100°C or below.

FIG. 5 shows an embodiment of a deposition unit or deposition unit assembly 150. Therein, a plate 522, which can be defined as a portion of the chamber 120, for example a side wall of the chamber 120, is provided and supports cathodes 152 and heating elements 154. According to some embodiments, which can be combined with other embodiments described herein, the supporting plate 522 can be connected with another chamber portion such that the substrate supported by the substrate guiding system is located between the cathodes 152 and the heating elements 154. In the example shown in FIG. 5, two processing areas, each having two cathodes, are provided.

According to some embodiments, the cathodes can for example be rotatable cathodes, such as rotatable targets for magnetron sputtering of the material to be deposited on the web.

According to yet further embodiments, a deposition unit or deposition unit assembly 160 can be provided as shown in Fig. 6. Thereby, a similar plate 622 which can be defined as a portion of the uniform platform or a portion of the chamber 120 supports cathodes 162 for PVD deposition processes of a layer onto a substrate. FIG. 6 shows two groups of three planar electrodes. These electrodes can for example be used for DC or RF sputtering. Thereby a drum, as e.g. provided by the drum 142 in FIG. 4, can be used as a counter electrode for the sputtering process.

According to yet further embodiments, which can be combined with other embodiments described herein, a gas separation unit 164 can be provided between one or more groups of cathodes 162. Thereby, the deposition areas or deposition zones through which the web is guided over a roller or the like can be separated such that a different atmosphere can be provided within the chamber 120. Accordingly, different processing gases or different pressure ranges can be applied to the respective deposition zones, thereby providing a further improved flexibility for manufacturing of consumer electronic and optoelectronic devices such as solar cells. For example, gas separation units may be incorporated to separate metallic from reactive PVD processes within different areas within the same vacuum chamber.

In light of the above described embodiments, a combination of system features can provide the modularity for PVD coating of flexible substrates.

According to embodiments described herein, a thin film deposition system for depositing a thin film on a flexible substrate as shown in FIG. 1 and as explained in more detail with respect to FIGS. 2A, 2B, and 3 to 6 can be used for depositing a back contact of a solar cell. Thereby, the free-span system having rotatable cathodes can be provided for depositing an aluminum layer with a sufficient surface roughness for diffuse scattering of photons in the solar cell. This process is typically conducted at a high temperature of 400°C or above. Thus, a free span web guiding system with heating plates can be used. After the first processing step at a high temperature, the second processing step of depositing aluminum doped zinc oxide is provided at essentially room temperature. In light thereof, according to some embodiments, gas cushion rollers, a cooling drum, and/or further cooling rollers are provided for lowering the temperature from the high temperature process to the low temperature process and controlling the temperature of the flexible substrate for the second deposition process.

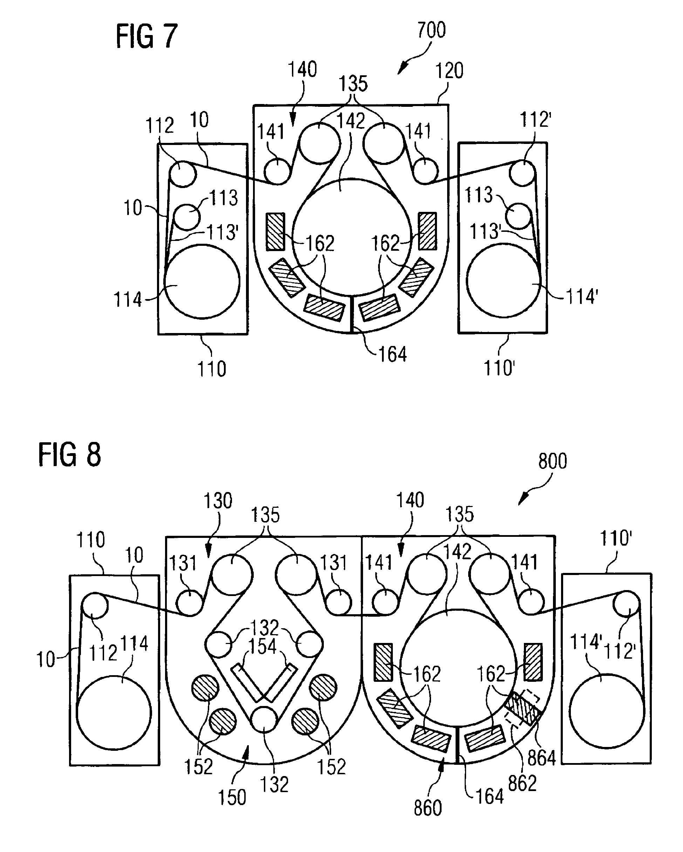

According to yet further embodiments, which can be combined with other embodiments described herein, the same platform of the chamber 120 can be provided for depositing a front contact of a flexible solar cell. Thereby, a chamber with a drum substrate guiding system and planar cathodes is used for depositing indium doped tin oxide (ITO). An example of the corresponding thin film deposition system 700 is shown in FIG. 7. FIG. 7 shows an unwinding station 110 and a winding station 110'.

Therein, an unwinding station 110 is provided with a roll 114 providing a flexible substrate 10. Further, the unwinding station 110 includes a guiding roller 112. Generally, one or more guiding rollers can be provided in order to guide the substrate to the subsequent chamber, to tension the web to the desired tension, to control the speed of the web, or the like.

According to yet further embodiments, which can be combined with other embodiments described herein, an interleaf layer can be wound between the layers of the flexible substrate on provided from and onto the roll 114. Thus, according to some embodiments, an interleaf layer, which can for example be made of a plastic material and which has been provided between the layers of the flexible substrate in a previous step, can be wound on the roll 113 in the unwinding chamber 110. Further, another interleaf layer such as a fresh interleaf layer can be wound from the roll 113 in the winding station 110', and can be fed between the layers of the flexible substrate. Thereby, a direct contact between the backside of the flexible substrate of one layer and the front side of the substrate of the subsequent layer can be avoided. In light of the above, an interleaf layer roll 113 can be provided. An interleaf layer can be provided when the substrate is on the roll 114, the substrate is transported through the deposition system without the interleaf layer, and another interleaf layer is again provided when the substrate is wound on another roll 114. According to yet further embodiments, the above described principle of providing an interleaf layer can be provided for any of the embodiments described herein. Thereby, it can be understood, that for the very first time a roll of substrate is used in a system, no interleaf layer is provided, and after the first deposition step an interleaf layer is inserted. Further, some steps might be less critical to a contact between the front and back surface of the web. Thus, after those steps an interleaf layer may also be omitted. Accordingly, different further embodiments may include an interleaf layer roll 113 on the winding side only or on the unwinding side only.

In the figures shown herein, the rollers 112 and 112' are schematically drawn such that the front surface of the substrate would be touched by the roller. It is to be understood, that due to other arrangements of rollers 112, 113, and 114, respectively, or due to additional rollers 112, a contact of the front surface of the web can be avoided. Such arrangements, which can be combined with any of the other embodiments described herein, yield yet further embodiments. Alternatively, rollers 112, 112' and/or other rollers may be provided as contact-less gas cushion roller, e.g. as described above.

From the unwinding station 110, the flexible substrate is guided to the deposition chamber 120 and further to the winding station where the flexible substrate is wound on a roll 114' in the winding station 110'. Again, the winding station 110' can include one or more rollers 112' in order to guide the flexible substrate and to control tension, winding characteristics, or the like.

According to yet further embodiments, the modularity of a thin film deposition system can be further increased as shown in FIG. 8. FIG. 8 shows a thin film deposition system 800 with an unwinding station 110, a winding station 110' and two chambers based on the common platform concept between the unwinding station and the winding station.

As shown in FIG. 8, a first chamber may include a free span substrate guiding system having rollers 132 such that the web is not in contact with a roller between the rollers 132, i.e. in the zones at which deposition takes place. According to some embodiments, which can be combined with other embodiments described herein, the free span substrate guiding system can be combined with a plurality of rotatable cathodes, for example magnetron sputtering cathodes, which are used to deposit the desired material onto the substrate 10. Typically, according to yet further embodiments, heating elements 154 are provided on the opposing side of the substrate 10 to heat the substrate to the desired temperature.

According to yet further embodiments, which can be combined with other embodiments described herein, the substrate guiding system used in the first (left) chamber of FIG. 8 further includes two gas cushion rollers 135, as described above.

After deposition in the first chamber, the substrate 10 is guided to the second (right) chamber. Therein, guiding rollers 141 can be provided similarly as the guiding rollers 131 in the last chamber. The substrate guiding system 140 in the right chamber 120 includes, in the example shown in FIG. 8, two gas cushion rollers 135 and a drum 142, which is described in more detail above and can be incorporated in this embodiment in a similar manner.

According to embodiments described herein, the substrate guiding system 140 in the right chamber and the substrate guiding system 130 in the left chamber can both be provided in the same chamber housing. In light of the above, according to different embodiments described herein, which can be combined with other embodiments described herein, the chamber 120 provides a common or uniform platform for different substrate guiding systems 130, 140 and different deposition units 150 and 160. Thus, the modularity of the deposition system can be provided. This improves the flexibility of a factory for manufacturing consumer electronic devices, it reduces the number of spare parts that need to be provided for avoiding significant downtimes of the deposition system, it increases the flexibility for combining different deposition processes, or reduces the costs for manufacturing deposition chambers and, thus, deposition systems.

As shown in FIG. 8, the deposition unit assembly 860 includes cathode support members 862, which support the sputtering cathodes 162. Thereby, according to some embodiments, the sputtering cathode support members 862 can be provided such that alternatively a gas separation unit can be supported instead of a sputtering cathode. Thus, during maintenance of the system or the like, a sputtering cathode 162 can be easily replaced by a gas separation unit 864. Thus, the gas separation unit 864 can be considered an optional gas separation unit. This exchange of cathodes and gas separation units permits the generation of even further processing areas with separated gas atmospheres. In light of the above, some embodiments described herein provide an even further flexibility or modularity by the possibility to exchange a cathode and a gas separation unit. Thus, for the thin film deposition system 800 shown in FIG. 8, two, three or four deposition areas with the ability to have different processing atmospheres can be provided. It is to be understood that according to yet further embodiments, particularly in the case of a deposition unit assembly having more than six cathodes or a system having more than six sputtering cathode support members, additional deposition areas for further deposition atmospheres can be provided. Thereby, different deposition processes can be conducted in the same processing chamber 120.

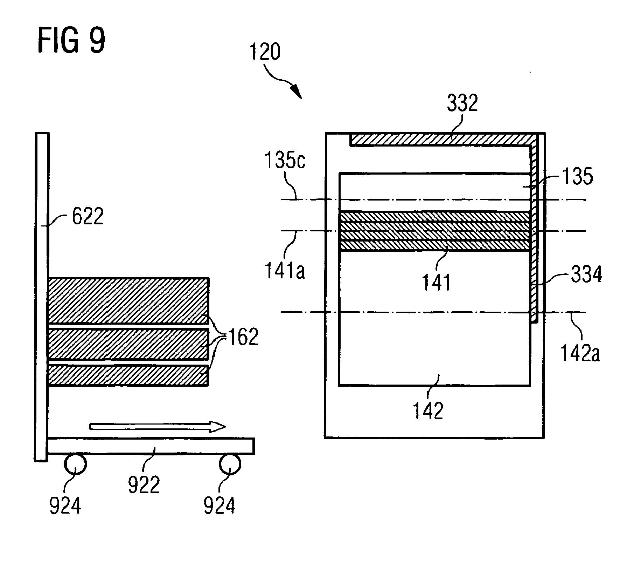

FIG. 9 illustrates the flexibility of the common platform concept in more detail. A chamber 120 providing a common platform is provided. As described above, a substrate guiding system can be provided within the chamber 120 by a support having the first support plate 332 and a second support plate 334. In the example shown in FIG. 9, a gas cushion roller 135, a guiding roller 141 and a drum 142 are supported by the support member. Each of the rollers or drums can rotate around their respective axes 135a, 141a, and 142a.

According to some embodiments, the deposition unit assembly illustrated by the cathodes 162 is supported by plate 622. As indicated by the arrow in FIG. 9, the plate and the deposition unit assembly supported by the plate can be moved such that the plate 622 is in a sealed contact with the other portions of the chamber 120. According to some embodiments, for example a bottom plate 922 and wheels 124 attached thereto can be provided for this movement.

Thereby, the deposition unit assembly and the substrate guiding unit can be separated while the substrate is in a guiding position through the deposition system. Accordingly the substrate can stay within the chamber 120 during maintenance for which the chamber is open. In other words, the substrate remains in the deposition area while the cathodes 162 can be removed (towards the left as shown in FIG. 9) and the chamber 120 can, for example be cleaned without the necessity to remove the substrate. This can, for example allow for easier maintenance.

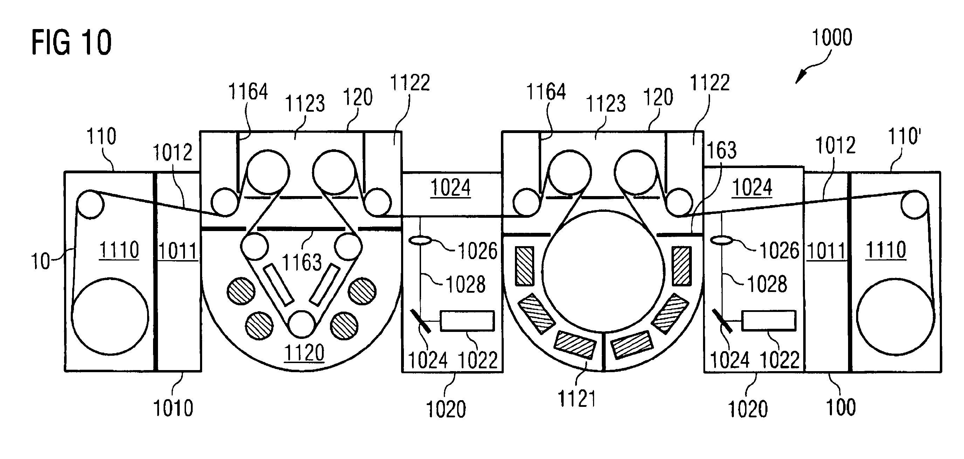

A further thin film deposition system 1000 is shown in figure 10. The thin film deposition system 1000 includes an unwinding station 110, a winding station 110', a first processing chamber and a second processing chamber, which has been described in detail with respect to figure 1 above. Additionally, a load lock chamber 1010 is provided between the unwinding station 110 and the first chamber 120. A further load lock chamber 1010 is provided between the chamber 1020 and the winding station 110'. The load lock chambers each include seals 1012, which can be closed for example while the flexible substrate is fed through the thin film deposition system or without the presence of the substrate. Thereby, the winding station and the unwinding station can be open and have atmospheric pressure while the remaining system is evacuated. Further, the load lock chambers can be used to provide an intermediate vacuum stage such that the pressure difference between the winding station and the processing chamber can be increased.

As shown for example in Fig. 10, the chambers and stations can separate the deposition system in different regions. According to some embodiments, these regions can similarly be provided in any of the other embodiments described herein. Thereby, separation means adapted for separating the regions can be provided based on the concept of a common platform in different regions. According to some embodiments, a gas separation 163 (see above), a gas separation 1163 and/or a gas separation 1164 can be provided. Thereby, different processing atmospheres, e.g., different processing pressures can be provided in different regions in the thin film deposition system.

For example, the system shows regions 1110 in the winding and unwinding station, regions 1011 in the load lock chambers 1010, regions 1024 in the laser scribing chambers 1020, gas cushion regions 1123 in the processing chambers 120, web guiding regions 1122 in the processing chambers 120, and processing regions 1121 and 1120 in the processing chambers. One or more of these regions each can have different atmospheres, e.g., pressures. For example, the gas insertion due to the gas cushion regions can be separated to reduce the influence on other regions by gas separation means.

According to different embodiments, which can be combined with other embodiments described herein, the regions 1123 for enclosing the gas cushion rollers 135 can have a pressure of 1 mbar to about 1·10-2 mbar, whereas during operation the other regions my be evacuated during operation to a pressure of 1·10-2 mbar to 1·10-4 mbar.

According to yet further embodiments, which can be combined with other embodiments described herein, after each of the processing chambers 120 a further substrate treating chamber 1020 is provided. The substrate treating chambers 1020 each include equipment for laser processing the front surface of the substrate. According to different embodiments, a laser 1022, one or more mirrors 1024, and/or at least one lens 1026 are provided in the laser scribing chambers 1020. A laser beam 1028 is guided onto the front surface of the substrate, i.e. the surface onto which the thin film has been deposited in the previous processing chamber 120. Thereby, the contacts for a solar cell can be defined by the laser scribing of the contact material.

According to some embodiments, which can be combined with other embodiments described herein, the processing chamber 120 is designed such as to allow a deposition of a transparent conductive oxide layer onto the substrate which is preferably a flexible substrate. The transparent conducive oxide TCO may be deposited by a sputtering process, especially a reactive sputtering process or Low Pressure Chemical Vapour Deposition LPCVD, so that the processing chamber 120 can be further equipped with a cathode evaporation device.

According to yet further embodiments, which can be an optional modification of other embodiments described herein, the TCO layer deposited in the treating chamber 6 may be an aluminium doped zinc oxide layer, a fluorine doped tin oxide (F-SnO), indium doped tin oxide (ITO) or a similar layer used in the photovoltaic industry for making the front contact.

The system 100 is designed to handle flexible substrates. In order to achieve a high electrical output from a solar cell module, the modules are made of an array of single photovoltaic cells being arranged in rows and columns adjacent to each other on the module. In order to produce such a plurality of separated photovoltaic cells, the layers deposited to form a photovoltaic structure are patterned or structured in order to form trenches in the respective layers so as to separate specific areas forming single photovoltaic cells. Accordingly, this process is also designated as trenching.

In light of the above, the system 1000 can include a further processing chamber 120 following successively the first chamber along the transport path of the web.

The patterning step in the treating chamber 1020 can be carried out by a laser process. Thereby, a laser having a laser beam focused by lens 1026 scans over the surface of the substrate or the layer deposited in the processing chambers, respectively, in order to cut a trench into said layer. Accordingly, this process is also designated as scribing a pattern or structure into a surface of the substrate. Instead of moving the laser beam over the surface to be treated, the substrate may be moved with respect to the fixed laser beam or combined movement may be carried out. Such a relative movement can also be applied to other patterning methods like mechanical patterning or maser patterning.

During the patterning step in treating chamber 1020, the particles removed by laser cutting may be blown away by a blowing gas stream of inert gas directed onto the surface of the substrate to be treated and/or sucked off from the surface of the substrate by suction means. For this purpose, nozzles for blowing inert gas onto the substrate as well as to suck off a surface area of the substrate may also be moved over the surface of the substrate similar to the laser beam. In addition, other cleaning processes may be simultaneously carried out during the patterning step. For example, electrostatic cleaning may be used. For this process, the substrate is set to a specific electrical potential in order to charge the particles removed by the laser beam. Spaced apart from the substrate, counter electrodes may be provided to electrically attract the charged particles and thereby remove the loose particles from the substrate.

Alternatively or in addition to the cleaning during the patterning step, a further treating chamber (not shown) for carrying out a cleaning step may be provided.

After depositing a semiconductor layer in the processing chamber 120, the substrate 10 is moved to the chamber 1020 wherein a patterning or structuring of the deposited layer is performed. For this purpose, a laser device 1022 is disposed inside or outside the vacuum chamber 1020. The laser device produces a focused laser beam 1028 which is directed onto the surface of the substrate 10 or the layer deposited thereon, respectively. If, according to some embodiments, the laser is provided outside the chamber, a window being transparent for the laser light produced by the laser is disposed in the respective sidewall of the chamber.

The laser light beam can be moved over the surface of the substrate in order to produce trenches. By the trenches, the deposited layer is divided into separate areas to form separate photovoltaic cells on a common substrate.

In light of the above, a plurality of embodiments have been described. For example, according to one embodiment, a system for thin film deposition on a flexible substrate having at least a first deposition region is provided. The system includes a first chamber being based on a platform, wherein the first deposition region is within the first chamber, wherein the first chamber has a first support member configuration configured for supporting at least two different substrate guiding systems and wherein one substrate guiding system is supported by the first support member configuration, and wherein the platform is configured for at least two different deposition units and wherein one deposition unit of the at least two different deposition units is enclosed by the first chamber. According to an optional modification thereof, the system may further include at least a second deposition region; and a second chamber being based on the platform, wherein the second deposition region is within the second chamber, wherein also the second chamber has one of the first support member configurations configure for supporting at least two different substrate guiding systems and wherein one substrate guiding system is supported by the first support member configuration, wherein the first chamber and the second chamber are both provided between unwinding and winding of the flexible substrate. According to yet further additional or alternative modifications, the at least two different substrate guiding systems can be selected from the group consisting of a free-span substrate guiding system and a cooling drum substrate guiding system; the at least two different substrate guiding systems may each include a gas cushion roller for guiding the flexible substrate with the surface of thin film deposition towards the gas cushion roller without mechanical contact to the roller, for example, such that the gas cushion roller is provided in a gas cushion region, which is separated from the first deposition regions such that different pressures can be provided in the gas cushion region and the first deposition region; the system can be a roll-to-roll thin film deposition system; and/or the system can be a PVD thin film deposition system. According to yet further embodiments, which can be combined with any of the other embodiments and modifications above, the first chamber can be adapted for depositing a first layer on the substrate and the second chamber is adapted for depositing a second layer above the first layer, and wherein a free-span substrate guiding system is disposed in the first chamber for allowing a deposition process at a first temperature above 200°C, e.g., above 300°C, and wherein a cooling roller substrate guiding system is disposed in the second chamber for allowing a deposition process at a temperature below 100°C; the free-span substrate guiding system can be disposed in the first chamber for allowing a deposition process at a first temperature above 300°C; a first deposition unit of the at least two deposition units can include two or more cathodes; and/or a first cathode of the two or more cathodes and a second cathode of the two or more cathodes can be disposed in different areas separated by a main gas separation unit. For example, the two or more cathodes are planar sputtering cathodes. According to yet further additional or alternative modifications at least four cathode support members can be provided such that at least two of the cathode support members are adapted to electively support a cathode or an optional gas separation unit, respectively; and/or at least one interleaf layer roll can be provided for winding an interleaf layer coming from between layers of the flexible substrate or unwinding an interleaf layer provided between layers of the flexible substrate.

According to another embodiment, a method of manufacturing a layer stack of a flexible photo voltaic cell is provided. The method includes unwinding a flexible substrate from a roll; guiding the flexible substrate in a first chamber being based on a common platform; depositing a first layer on the flexible substrate; guiding the flexible substrate from the first chamber to a second chamber, wherein the second chamber is based on the second platform; depositing a second layer above the first layer; guiding the flexible substrate from the second chamber; and winding the flexible substrate on a roll. According to an optional modification thereof the method can further include heating the substrate to a temperature of 300°C or above for the depositing of the first layer; and cooling the substrate to a temperature of 100°C or below for the depositing of the second layer. According to yet further embodiments, which can be combined with the above modification or the above embodiment, the transport speed of the flexible substrate can be from 0.1 m/min to 10 m/min, typically from 1 m/min to 5 m/min; the time between the depositing of the first layer and the time between depositing the second layer can be 60 min or less, typically 5 min or less; the depositing of the first layer can be conducted on a free-span substrate guiding system, and wherein the depositing of the second layer is conducted on a cooling drum substrate guiding system; the substrate can be guided over a gas cushion roller at least for the guiding of the flexible substrate from the first chamber to a second chamber; the substrate can be exposed to at least two different deposition atmospheres in the first and/or the second chamber; and/or a thin film deposition system according to any of the embodiments described herein can be used for the manufacturing of the layer stack of the flexible photo voltaic cell.

According to embodiments described herein, the chambers can be provided in a modular manner such that between unwinding and winding, free-span and cooling rollers can be combined. A combination or switching between free-span and cooling rollers can be provided based on a common platform.

While the foregoing is directed to embodiments of the invention, other and further embodiments of the invention may be devised without departing from the basic scope thereof, and the scope thereof is determined by the claims that follow.

## Claims

1. A system for thin film deposition on a flexible substrate having at least a first deposition region, the system comprising:
a first chamber being based on a platform, wherein the first deposition region is within the first chamber, wherein the first chamber has a first support member configuration configured for supporting at least two different substrate guiding systems and wherein one substrate guiding system is supported by the first support member configuration, and wherein the platform is configured for at least two different deposition units and wherein one deposition unit of the at least two different deposition units is enclosed by the first chamber.

2. The system according to claim 1, further comprising at least a second deposition region; and
a second chamber being based on the platform, wherein the second deposition region is within the second chamber, wherein also the second chamber has one of the first support member configurations configure for supporting at least two different substrate guiding systems and wherein one substrate guiding system is supported by the first support member configuration, wherein the first chamber and the second chamber are both provided between unwinding and winding of the flexible substrate.

3. The system according to any of claims 1 to 2, wherein the at least two different substrate guiding systems are selected from the group consisting of a free-span substrate guiding system and a cooling drum substrate guiding system.

4. The system according to any of claims 1 to 3, wherein the at least two different substrate guiding systems each comprises a gas cushion roller for guiding the flexible substrate with the surface of thin film deposition towards the gas cushion roller without mechanical contact to the roller.

5. The system according to any of claims 1 to 4, wherein the gas cushion roller is provided in a gas cushion region, which is separated from the first deposition regions such that different pressures can be provided in the gas cushion region and the first deposition region.

6. The system according to any of claims 1 to 5, wherein the system is a roll-to-roll thin film deposition system.

7. The system according to any of claims 2 to 6, wherein the first chamber is adapted for depositing a first layer on the substrate and the second chamber is adapted for depositing a second layer above the first layer, and wherein a free-span substrate guiding system is disposed in the first chamber for allowing a deposition process at a first temperature above 200°C, particularly above 300°C, and wherein a cooling roller substrate guiding system is disposed in the second chamber for allowing a deposition process at a temperature below 100°C.

8. The system according to any of claims 1 to 7, wherein a first deposition unit of the at least two deposition units includes two or more cathodes.

9. The system according to claim 8, wherein at least four cathode support members are provided such that at least two of the cathode support members are adapted to electively support a cathode or an optional gas separation unit, respectively.

10. The system according to any of claims 1 to 9, wherein at least one interleaf layer roll is provided for winding an interleaf layer coming from between layers of the flexible substrate or unwinding an interleaf layer provided between layers of the flexible substrate.

11. A method of manufacturing a layer stack of a flexible photo voltaic cell, comprising:
unwinding a flexible substrate from a roll;
guiding the flexible substrate in a first chamber being based on a common platform;
depositing a first layer on the flexible substrate;
guiding the flexible substrate from the first chamber to a second chamber, wherein the second chamber is based on the second platform;
depositing a second layer above the first layer;
guiding the flexible substrate from the second chamber; and
winding the flexible substrate on a roll.

12. The method according to claim 11, further comprising:
heating the substrate to a temperature of 300°C or above for the depositing of the first layer; and
cooling the substrate to a temperature of 100°C or below for the depositing of the second layer.

13. The method according to any of claims 11 to 12, wherein the time between the depositing of the first layer and the time between depositing the second layer is 60 min or less, typically 5 min or less.

14. The method according to any of claims 11 to 13, wherein the depositing of the first layer is conducted on a free-span substrate guiding system; and wherein the depositing of the second layer is conducted on a cooling drum substrate guiding system.

15. The method according to any of claims 11 to 14, wherein a system according to any of claims 1 to 11 is used for the manufacturing of the layer stack of the flexible photo voltaic cell.

## Amended claims

### Amended claims in accordance with Rule 137(2) EPC.

**1.** A system (100, 700, 800) for thin film deposition on a flexible substrate (10) having at least a first deposition region, the system comprising:
a first chamber (120) being based on a platform, wherein the first deposition region is within the first chamber, wherein the first chamber has a first support member configuration (332, 334) configured for supporting at least two different substrate guiding systems (130, 140) and wherein one substrate guiding system is supported by the first support member configuration, and wherein the platform is configured for at least two different deposition units (150, 160) and wherein one deposition unit of the at least two different deposition units is enclosed by the first chamber.

**2.** The system according to claim 1, further comprising at least a second deposition region; and
a second chamber (120) being based on the platform, wherein the second deposition region is within the second chamber, wherein also the second chamber has one of the first support member configurations (332, 334) configured for supporting at least two different substrate guiding systems (130, 140) and wherein one substrate guiding system is supported by the first support member configuration, wherein the first chamber and the second chamber are both provided between unwinding and winding of the flexible substrate.

**3.** The system according to any of claims 1 to 2, wherein the at least two different substrate guiding systems are selected from the group consisting of a free-span substrate guiding system and a cooling drum substrate guiding system.

**4.** The system according to any of claims I to 3, wherein the at least two different substrate guiding systems (130, 140) each comprises a gas cushion roller (135) for guiding the flexible substrate with the surface of thin film deposition towards the gas cushion roller without mechanical contact to the roller.

**5.** The system according to any of claims 1 to 4, wherein the gas cushion roller is provided in a gas cushion region, which is separated from the first deposition regions such that different pressures can be provided in the gas cushion region and the first deposition region.

**6.** The system according to any of claims 1 to 5, wherein the system is a roll-to-roll thin film deposition system.

**7.** The system according to any of claims 2 to 6, wherein the first chamber is adapted for depositing a first layer on the substrate and the second chamber is adapted for depositing a second layer above the first layer, and wherein a free-span substrate guiding system is disposed in the first chamber for allowing a deposition process at a first temperature above 200°C, particularly above 300°C, and wherein a cooling roller substrate guiding system is disposed in the second chamber for allowing a deposition process at a temperature below 100°C.

**8.** The system according to any of claims 1 to 7, wherein a first deposition unit of the at least two deposition units includes two or more cathodes (152, 162).

**9.** The system according to claim 8, wherein at least four cathode support members (622, 922) are provided such that at least two of the cathode support members are adapted to electively support a cathode or an optional gas separation unit (163, 164, 864, 1163, 1164), respectively.

**10.** The system according to any of claims 1 to 9, wherein at least one interleaf layer roll (113) is provided for winding an interleaf layer (113') coming from between layers of the flexible substrate or unwinding an interleaf layer provided between layers of the flexible substrate.

**11.** A method of manufacturing a layer stack of a flexible photo voltaic cell, comprising:
unwinding a flexible substrate (10) from a roll (114);
guiding the flexible substrate in a first chamber (120) being based on a common platform;
depositing a first layer on the flexible substrate;
guiding the flexible substrate from the first chamber to a second chamber (120), wherein the second chamber is based on the common platform;
depositing a second layer above the first layer;
guiding the flexible substrate from the second chamber; and
winding the flexible substrate on a roll (114').

**12.** The method according to claim 11, further comprising:
heating the substrate to a temperature of 300°C or above for the depositing of the first layer; and
cooling the substrate to a temperature of 100°C or below for the depositing of the second layer.

**13.** The method according to any of claims 11 to 12, wherein the time between the depositing of the first layer and the time between depositing the second layer is 60 min or less, typically 5 min or less.

**14.** The method according to any of claims 11 to 13, wherein the depositing of the first layer is conducted on a free-span substrate guiding system; and wherein the depositing of the second layer is conducted on a cooling drum substrate guiding system.

**15.** The method according to any of claims 11 to 14, wherein a system according to any of claims 1 to 11 is used for the manufacturing of the layer stack of the flexible photo voltaic cell.
